(19) Europäisches Patentamt
European Patent Office
Office européen des brevets

(11) EP 3 587 350 A1

(12) EUROPEAN PATENT APPLICATION
published in accordance with Art. 153(4) EPC

(43) Date of publication:
01.01.2020 Bulletin 2020/01

(51) Int Cl.:
C01G 33/00 (2006.01)    H01L 29/786 (2006.01)

(21) Application number: 18758245.7

(22) Date of filing: 22.01.2018

(86) International application number:
PCT/JP2018/001729

(87) International publication number:
WO 2018/155034 (30.08.2018 Gazette 2018/35)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD TN

(30) Priority: 23.02.2017 JP 2017032113

(71) Applicant: National Institute of Advanced
Industrial Science
and Technology
Tokyo 100-8921 (JP)

(72) Inventors:
• KIKUCHI, Naoto
  Tsukuba-shi
  Ibaraki 305-8568 (JP)
• AIURA, Yoshihiro
  Tsukuba-shi
  Ibaraki 305-8568 (JP)
• SAMIZO, Akane
  Tsukuba-shi
  Ibaraki 305-8568 (JP)
• IKEDA, Shintarou
  Tsukuba-shi
  Ibaraki 305-8568 (JP)

(74) Representative: Locas, Davide et al
Cantaluppi & Partners S.r.l.
Piazzetta Cappellato Pedrocchi, 18
35122 Padova (IT)

(54) OXIDE SEMICONDUCTOR AND SEMICONDUCTOR DEVICE

(57)    Provided are an oxide semiconductor excellent in transparency, mobility, and weatherability, etc., and a semiconductor device having the oxide semiconductor, a p-type semiconductor being realizable in the oxide semiconductor. The oxide semiconductor consists of a composite oxide, which has a crystal structure including a foordite structure and contains Nb and Sn elements, and its holes become charge carriers by the condition that $Sn^{4+} / (Sn^{2+} + Sn^{4+})$ which is a ratio of $Sn^{4+}$ to a total amount of Sn in the composite oxide is $0.006 \leq Sn^{4+} / (Sn^{2+} + Sn^{4+}) \leq 0.013$.

FIG. 2

EP 3 587 350 A1

**Description**

**TECHNICAL FIELD**

The present invention relates to an oxide semiconductor and a semiconductor device that consist of a composite oxide containing Sn, more particularly, an oxide semiconductor capable of realizing p-type semiconductor characteristics.

**BACKGROUND ART**

Conventionally, a transparent semiconductor material having high transparency in a visible light region and exhibiting high electrical conductivity is known as an oxide composite, and is widely used for a transparent electrode etc. For example, $In_2O_3$, ZnO, and $SnO_2$, and Sn-added $In_2O_3$, Al-added ZnO, Ga-added ZnO, Sb-added $SnO_2$, and F-added $SnO_2$, etc. obtained by adding an impurity to these base materials are known as transparent semiconductors, but those are n-type semiconductors in which all electrons become charge carriers. Meanwhile, semiconductors include p-type semiconductors in which holes are used as charge carriers. If the n-type and p-type semiconductors that are transparent in the visible light region are arranged in numbers etc., formation of a pn junction due to them makes it possible to produce diodes, transistors, and solar cells, etc. that are transparent in the visible light region.

$Cu_2O$ and NiO, etc. have been already known as p-type semiconductors, but are not transparent because they have light absorption in the visible light region and strong coloring. Since 1990, research and development of transparent p-type semiconductors have been promoted, and some new transparent p-type semiconductors have been reported. For example, reported have been: an oxide composite represented by a chemical formula of $ABO_2$ having a delafossite structure (A = at least one kind of Cu or Ag, B = at least one kind of Al, Ga, In, Sc, Y, Cr, Rh or La) ; an oxychalcogenide compound represented by a chemical formula of LnCuOCh (Ln = at least one kind of lanthanoid element or Y, Ch = at least one kind of S, Se, or Te); zinc oxide represented by a chemical formula of ZnO; and the like. However, a compound having the delafossite structure has low mobility of holes. Additionally, the oxychalcogenide compound has considerably high mobility and concentration of holes, but it is oxidized in an air atmosphere and deterioration in its characteristics is remarkable. Further, zinc oxide is originally an n-type semiconductor having electrons as charge carriers, thus needing to reduce, to the limit, concentration of structural defects for generating electrons and introduce structural defects that lead to expression of p-type semiconductor characteristics such as nitrogen. Such necessity makes it difficult to generate the n-type structural defects and/or reduce the concentration of the n-type structural defects due to the introduction of the p-type structural defects, which makes it further difficult to produce zinc oxide having the p-type semiconductor characteristics and leads to deterioration in reproducibility. Therefore, it is difficult to realize a transparent p-type semiconductor suitable for electronic devices.

Oxide semiconductors are expected as semiconductor materials resistant to oxidation reactions in the atmosphere containing oxygen. However, it is difficult to realize p-type conductivity with oxides. This is because the oxide has a structure in which electrons at a top of its valence band are localized on oxygen ions. A delafossite compound introduces d-orbital components of metal into a top of its valence band, and an oxychalcogenide compound introduces p-orbital components of a chalcogen element into a top of its valence band, thereby reducing the localization of electrons at each top of the valence bands. Then, if an s-orbit of a metal element having an electron's orbital radius larger than d-orbital and p-orbital radii is introduced into a top of its valence band, the introduction brings expectation of: reduction in the electron's localization at the top of the valence band; and achievement of having high mobility. Additionally, what is expected by an isotropic spherical structure of an s-orbit is to suppress deterioration in mobility with respect to disturbance in crystal structure, the disturbance causing variations in bonding angles or/and bonding distances. Based on such viewpoints, the followings have been reported: p-channel transistors are produced by using tin oxide (SnO) in which s-orbital components of tin are introduced into a top of its valence band (see, for example, Patent Document 1). Further, a band gap of SnO is 0.7 eV that is smaller energy than that in a visible light region, and so is strongly colored in the visible light region. Consequently, known is that transparency in the visible light region cannot be ensured.

There are the following known documents related to a foordite oxide.

Foordite is represented by general formula $SnNb_2O_6$ and has a crystal structure belonging to a monoclinic system of: lattice constants a = 1.7093 nm, b = 0.4877 nm, c = 0.5558 nm, $\beta$ = 90.85°; and a space group C2 / c (see Non-Patent Document 1). Incidentally, the name of foordite has been taken from the name of the American mineralogist Eugene E. Foord.

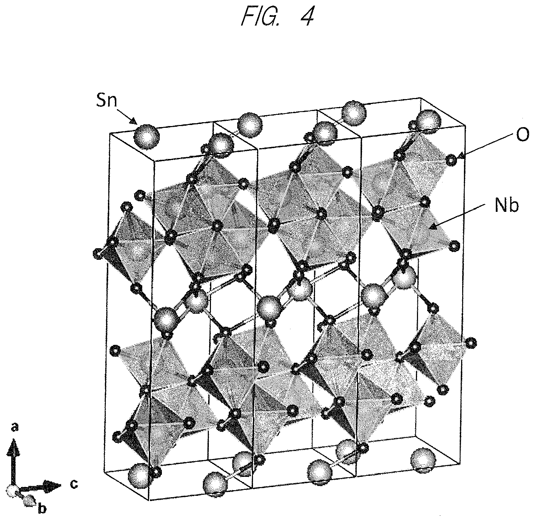

FIG. 4 is a drawing showing a crystal structure of an oxide composite $SnNb_2O_6$ that represents a foordite structure. The figure shows a case where three unit lattices are continuously arranged in a c-axis direction. Nb forms an $Nb_2O_6$ octahedron surrounded by oxygen, and the octahedron is layeredly linked (coupled) in an a-axis direction through Sn.

Reported has been a metal oxide having a foordite structure represented by a composition formula $SnNb_2O_6$, a top of a valence band of the metal oxide being composed of a 5s-component of Sn (see Non-Patent Document 2).

There is a report that foordite of a natural mineral contains $Sn^{4+}$ having an amount of less than 3 % with respect to the total Sn amount ($Sn^{2+}$ + $Sn^{4+}$) (see Non-Patent Document 3). However, this report indicates that foordite is a natural mineral and so has A = Sn + Pb, B = Nb + Ta when being expressed as $AB_2O_6$ in a general chemical formula. Also reported is that foordite contains impurity components such as Fe, Mn, Ca and Na by its composition analysis (see Non-Patent Document 3).

Reported is that: $SnNb_2O_6$ synthesized in a solid-phase reaction of SnO and $Nb_2O_5$ shows a foordite structure; and an amount of $Sn^{4+}$ is zero by $^{119}Sn$ Mossbauer spectrometry (see Non-patent Document 4). This report indicates that $SnNb_2O_6$ is not a natural mineral, and so contains no impurities shown in Non-Patent Document 3.

Reported is that a compound supporting Ir functions as a photocatalyst about $SnNb_2O_6$ having a foordite structure or about $Sn_{0.95}Sr_{0.05}Nb_2O_6$ obtained by partially substituting Sn with Sr, light irradiation decomposing water by the photocatalyst to generate oxygen (see Non-Patent Document 2). Additionally, reported is that $SnNb_2O_6$ supporting Pt functions as a photocatalyst by which light irradiation decomposes water to generate hydrogen (see Non-Patent Document 2).

Reported is that $Sn_2Nb_2O_7$, which has a pyrochlore structure and contains $Sn^{2+}$ and $Nb^{5+}$, has a structural defect represented as $Sn_{2-p}(B_{2-q}Sn_q)O_{7-p-0.5q}$ (See Non-Patent Document 5).

## RELATED ART DOCUMENTS

## PATENT DOCUMENTS

Patent Document 1: International Publication No. WO2010/010802
Patent Document 2: Japanese Patent Application Laid-open No. 2006-88019

## NON-PATENT DOCUMENTS

Non-Patent Document 1: T. S. Ercit, P. Cerny, The Canadian Mineralogist 26, 899-903 (1988)
Non-Patent Document 2: Y. Hosogi, Y. Shimodaira, H. Kato, H. Kobayashi, A Kudo, Chemistry of Materials 20, 1299 (2008)
Non-Patent Document 3: P. Cerny, A-M. Fransolet, T. S. Ercit, R. Chapman, The Canadian Mineralogist 26, 889 (1988)
Non-Patent Document 4: L. P. Cruz, J. -M. Savariult, J. Rocha, J. -C. Jumas, J. D. Pedrosa, Journal of Solid State Chemistry 156, 349 (2001)
Non-Patent Document 5: M. A. Subramanian, G. Aravamudan, G. V. Subba Rao, Progress in Solid State Chemistry 15, 55 (1983)

## SUMMARY OF THE INVENTION

## PROBLEMS TO BE SOLVED BY THE INVENTION

Conventionally, transparent p-type semiconductors suitable for electronic devices have been difficult to realize in oxide semiconductors resistant to oxidation reactions in the atmosphere containing oxygen. Particularly, if transparent n-type and p-type semiconductors are prepared in the visible light region, a pn junction can be formed, which brings expectation of realizing the transparent semiconductor devices. However, such realization is difficult.

The present invention is intended to solve these problems. The present invention has an object of providing: a novel oxide semiconductor whose light absorption is less in a visible light region and which can realize high mobility of charge carriers; and a semiconductor device including such an oxide semiconductor.

The present invention also has an object of providing: an oxide semiconductor exhibiting p-type semiconductor characteristics; and a semiconductor device including such an oxide semiconductor.

## MEANS FOR SOLVING THE PROBLEMS

The present invention has the following features to achieve the above objects.

(1) An oxide semiconductor consists of a composite oxide that has a crystal structure including a foordite structure and contains Nb and Sn elements, in which $Sn^{4+} / (Sn^{2+} + Sn^{4+})$ that is a ratio of $Sn^{4+}$ to a total amount of Sn in the composite oxide is $0.006 \leq Sn^{4+} / (Sn^{2+} + Sn^{4+}) \leq 0.013$, and its holes become charge carriers.

(2) In the oxide semiconductor according to (1), the composite oxide is an oxide representing $AB_2O_6$ (A is Sn, and B is Nb) by a general chemical formula.

(3) In the oxide semiconductor according to (1) or (2), at least one or more kinds of elements selected from a group composed of W, Zr, V, Mn, Ti, Ga, Hf, and Mo is added as an additive element.

(4) In the oxide semiconductor according to (3), a total amount of the additive element is 0.001 atom% or more and 10 atom% or less.

(5) A semiconductor device including the oxide semiconductor according to any one of (1) to (4).

## EFFECTS OF THE INVENTION

According to the present invention, a transparent and high-mobility semiconductor having a wide gap can be realized in the oxide semiconductor. Further, a p-type oxide semiconductor can be realized by the oxide semiconductor of the present invention. According to the present invention, when the ratio $Sn^{4+} / (Sn^{2+} + Sn^{4+})$ of $Sn^{4+}$ to the total amount of Sn in a substance is $0.006 \leq Sn^{4+} / (Sn^{2+} + Sn^{4+}) \leq 0.013$, a p-type can be realized by generating a structural defect $Sn'_{Nb}$ in which $Sn^{4+}$ substitutes a part of an Nb site of structural formula $SnNb_2O_6$ having a foordite structure.

In the oxide semiconductor of the present invention, a top of its valence band is formed of a 5s component of Sn. Consequently, since an s-orbital has an isotropic spherical shape with a large orbital radius, effects of deteriorating localization of electrons and achieving high mobility even for structural disorder are obtained.

Since the semiconductor of the present invention consists of the oxide and has weatherability, an electronic device excellent in weatherability can be realized by forming a pn junction of the p-type oxide semiconductor of the present invention and an n-type oxide semiconductor.

The oxide semiconductor of the present invention shows that its band gap (Eg) is 2.3 eV in $SnNb_2O_6$ exhibiting a foordite structure, and so can realize a wide gap and has high transparency in the visible light region.

In the oxide semiconductor of the present invention, at least one or more kinds of elements selected from the group consisting of W, Zr, V, Mn, Ti, Ga, Hf, and Mo may be added, and the oxide semiconductors containing additive elements show properties (effects) similar to those in a case of containing no additive element. When an additive element is contained, for example, the oxide semiconductor preferably contains 0.001 to 10 atom% in the total of the additive elements, and can realize a p-type oxide semiconductor.

Since the semiconductor device of the present invention includes the oxide semiconductor having the above-described effects, the following operations and effects can be expected. By forming the pn junction made of the oxide semiconductor of the present invention, realized can be a transistor, a diode, and an integrated circuit that further uses its rectification characteristics. Additionally, the semiconductor device can be applied also to a light-emitting diode and a solar cell that corresponds to a band gap of a semiconductor constituting a pn junction.

## BRIEF DESCRIPTION OF THE DRAWINGS

FIG. 1 is a drawing showing X-ray diffraction patterns in a case of oxide composite $SnNb_2O_6$ (data of sample numbers 1-4 and ICDD) in a first embodiment;

FIG. 2 is a drawing showing, in the first embodiment, $^{119}$Sn Mossbauer spectrum (solid line) measured at 300 K in the case of oxide composite $SnNb_2O_6$ (sample numbers 1-3), and $^{119}$Sn Mossbauer spectrum measured at 300 K in a case of oxide composite $SnNb_2O_6$ (sample number 4) represented by a thin line indicating that $Sn^{4+}$ hardly exists;

FIG. 3 is a drawing showing $^{119}$Sn Mossbauer spectrum at each measurement temperature of 300 K and 78 K in the case of oxide composite $SnNb_2O_6$ (sample number 1) in the first embodiment; and

FIG. 4 is a drawing showing a crystal structure of oxide composite $SnNb_2O_6$ representing a foordite structure.

## DETAILED DESCRIPTION OF PREFERRED EMBODIMENTS

Embodiments of the present invention will be described below.

The inventors of the present invention have: paid attention to, in an oxide composite with a foordite structure, an influence on semiconductor characteristics exerted in accordance with a ratio $[Sn^{4+} / (Sn^{2+} + Sn^{4+})]$ of $Sn^{4+}$ to the total amount of Sn in an oxide composite; researched and developed the oxide composite; and obtained an oxide semiconductor having excellent semiconductor characteristics and p-type semiconductor characteristics.

An oxide semiconductor according to an embodiment of the present invention is a semiconductor: enhancing ionicity of bonding by forming a double oxide with $Nb_2O_5$ with respect to SnO having a small band gap, a top of whose valence band is composed of a 5s orbital of Sn; mainly having a foordite structure as a crystal structure about composition formula $SnNb_2O_6$ that realizes a band gap made wide; and indicating that a ratio $Sn^{4+} / (Sn^{2+} + Sn^{4+})$ of $Sn^{4+}$ to the total amount of Sn is $0.006 \leq Sn^{4+} / (Sn^{2+} + Sn^{4+}) \leq 0.013$.

Additionally, the oxide semiconductor according to the embodiment of the present invention is found to be a semiconductor that: is described in a simplified manner by a general formula of $SnNb_2O_6$ as a stoichiometric composition; and has a structural defect in which a part of $Sn^{2+}$ contained to forms holes serving as p-type charge carriers is oxidized to $Sn^{4+}$ and a part of an $Nb^{5+}$ site is substituted, such a structural defect being represented as "$Sn'_{Nb}$" by the Kroger-Vink notation that is a notation of a structural defect.

Sn can change its valence relatively easily, and take $Sn^0$ and $Sn^{4+}$ in addition to $Sn^{2+}$. For example, $Sn_2Nb_2O_7$, which is an oxide composite containing $Sn^{2+}$ and $Nb^{5+}$ similarly to $SnNb_2O_6$, has been reported as described in the background art. That is, known has been that $Sn_2Nb_2O_7$ has a structural defect as represented by $Sn_{2-p}(B_{2-q}Sn_q)O_{7-p-0.5q}$ (see Non-Patent Document 5). Here, the above-mentioned defect is such a structural defect that a defect $Sn'_{Nb}$, in which $Sn^{4+}$ corresponding to q is substituted for $Nb^{5+}$, exists in addition to $V''_{Sn}$ which is a Sn deficiency corresponding to p and any of both cases brings generation of holes. Therefore, the generation of those defects to $SnNb_2O_6$ is found to become a center of the structural defect that leads to the generation of holes in any case.

Here, the ratio $Sn^{4+} / (Sn^{2+} + Sn^{4+})$ of $Sn^{4+}$ to the total Sn amount of $(Sn^{2+} + Sn^{4+})$ indicates that the defect "$Sn'_{Nb}$", in which the $Nb^{5+}$ site is substituted for $Sn^{4+}$, is reflected as long as precipitation of $SnO_2$ is not recognized.

Meanwhile, reported has been that a natural mineral foordite contains $Sn^{4+}$ although its content is less than 3% (see Non-Patent Document 3). On the other hand, foordite synthesized from reagents does not contain $Sn^{4+}$ (see Non-Patent Document 4). A difference between these is considered as follows: the natural mineral contains impurity components having valences other than valences of $A^{2+}$ and $B^{5+}$ in general chemical formula $AB_2O_6$, and a part of Sn easily variable in valences has indicated tetravalent in order to balance charges with these impurities. None of oxide composites of foordite structures each containing Sn have conventionally exhibited p-type semiconductor characteristics including Non-Patent Documents 3 and 4. This is considered as follows: conditions for generating an appropriate amount of $Sn^{4+}$, a defect $Sn'_{Nb}$ substituting a B site, and a defect $V''_{Sn}$ lacking $Sn^{2+}$ have not been found and, additionally thereto, the generations of a minus monovalent defect $Sn'_{Nb}$ and a minus divalent defect $V''_{Sn}$ simultaneously brings the generation of plus divalent oxygen deficiency $V''_O$, so that expression of p-type conduction due to the generation of holes cannot be obtained for charge compensation. Amounts of generations of the structural defects "$Sn'_{Nb}$", "$V''_{Sn}$", and "$V''_O$" considered here are considered to depend on temperature and atmosphere gas conditions at a time of producing the oxide composite. In the present invention, appropriately controlling the temperature and atmosphere gas conditions at a time of sample preparation brings a discovery of the optimum condition that "$Sn'_{Nb}$" is generated and "$V''_O$" is hardly generated. Such a discovery is considered to lead to the expression of the p-type semiconductor characteristics. The p-type semiconductor characteristics are expressed also in the form of bulk or thin film.

An oxide of the present invention, which has the crystal structure including the foordite structure, only has to mainly include a crystal structure of a foordite structure. Incidentally, the term "mainly" refers to, for example, more than 50 weight% of the whole. Of course, the entire crystal structure is preferably composed of foordite structures. However, the oxide can be permitted to be composed of a crystal structure slightly having a structure other than the foordite structure, and it is preferable that the crystal structure is substantially composed of the foordite structures. The term "substantially" means, for example, 80 weight% or more.

Exemplified as a semiconductor device according to the present invention is a pn junction element in which a pn junction is formed by a p-type semiconductor of the present embodiment and an n-type semiconductor. Given as the n-type semiconductors suitable for the pn junction element are: $In_2O_3$, $ZnO$, and $SnO_2$; Sn-added $In_2O_3$, Al-added $ZnO$, Ga-added $ZnO$, Sb-added $SnO_2$, and F-added $SnO_2$ in which impurities are added to those host materials; and the like. Particularly, $ZnO$ is preferable in that it has a feature capable of production from an insulator to a semiconductor due to easiness of control of carrier concentration and, additionally thereto, is capable of easy etching in patterning and has no problem of using a rare raw material.

(First Embodiment)

In the present embodiment, explained will be an oxide semiconductor containing Sn and Nb and including an oxide composite that has a crystal structure including a foordite structure. Examined in an oxide composite having a foordite structure consisting of Sn, Nb and oxygen have been characteristics corresponding to a ratio $Sn^{4+} / (Sn^{2+} + Sn^{4+})$ of $Sn^{4+}$ to an amount of $(Sn^{2+} + Sn^{4+})$. As described below, when $Sn^{4+} / (Sn^{2+} + Sn^{4+})$ satisfies $0.006 \leq Sn^{4+} / (Sn^{2+} + Sn^{4+}) \leq 0.013$, p-type semiconductor characteristics in which holes are used as charge carriers lead to expression.

[Production of Oxide Composite with Crystal Structure containing Sn and Nb and including Foordite Structure]

2.030 g of SnO powder (High purity Materials KOJUNDO CHEMICAL LABORATORY CO. LTD, 99.5% purity), and 3.992 g of $Nb_2O_5$ powder (High purity Materials KOJUNDO CHEMICAL LABORATORY CO. LTD, 99.9% purity) were weighed, and the weighed powders were placed in a mortar made of agate and were wet-mixed for about 1 hour while ethanol (Wako Pure Chemical Corporation, special grade) was added thereto. At this time, SnO and $Nb_2O_5$ were mixed so that a ratio (Sn / Nb) of Sn to Nb was 0.50 in atomic ratio.

Thereafter, the mixture was left overnight at room temperature to dry the ethanol, and was divided into 6 powder groups approximately equal to one another. Each power group was uniaxially pressurized (15 mm in diameter, 170 MPa) to produce six disk-shaped green compacts. The green compacts were placed on an alumina boat, put in an electric furnace having an alumina core tube whose diameter is 50 mm and whose length is 800 mm, and were temporarily calcined at 1173 K for 4 hours while nitrogen gas was caused to flow therein at a flow rate of 150 ml / minute. The temporarily calcined green compacts were crushed in the agate mortar, were mixed with ethanol after addition of a polyvinyl alcohol aqueous solution as a binder to a sample by 2 wt.%, and were left overnight at room temperature for drying. Then, the dried samples were sifted so that each of their particle size is adjusted to 212 $\mu$m or less, and were subjected to hydrostatic molding (285 MPa) after their uniaxial pressurization (15 mm in diameter, 170 MPa). Consequently, compacts each having a diameter of about 15 mm and a thickness of about 1.2 mm were produced. The obtained compacts were placed on an alumina boat, and were subjected to main calcination within a range of 1053 K to 1473 K for 4 hours while nitrogen gas is caused flow (flow rate: 50 ml / min). Main calcination temperature of each sample is shown in Table 1 described later.

[Percentage of Sn Valence and Electric Characteristics]

Identification of crystal structures of the obtained samples were performed by using an X-ray diffractometer (PANalytical, X' Pert Pro MRD). A composition ratio of (Sn / Nb) after the calcination was estimated by using a wavelength dispersion type fluorescence X-ray analyzer (Rigaku, ZSX). Electrical characteristics of the samples were evaluated by using a Hall effect measuring device (TOYO Corporation, Resitest 8310) through a Van der Pauw placement after a sample in which gold electrodes were deposited on four corners of a circular sample was prepared. Seebeck coefficients of the samples were evaluated by using a thermoelectric characteristic evaluation device (ADVANCE RICO, inc., ZEM-3). The measurements of the X-ray diffraction, fluorescence X-ray, and the Hall effect measurements were performed at 300 K, and the Seebeck measurements were performed at 323 K. The estimation of Sn contents of $Sn^{4+}$ and $Sn^{2+}$ in each sample was made by a Mossbauer spectroscopy through a transmission method. Measurements were made at two points of room temperature (300 K) and liquid nitrogen temperature (78 K). The obtained $^{119}$Sn Mossbauer spectrum was subjected to least squares fitting using the Lorentz curve, and integrated intensity of absorption peaks, that is, integrated absorption intensity was found. Here, since a tetravalent Sn site and a bivalent Sn site are different in temperature dependence of recoil-free fraction f (Debye temperatures are different), there are tendencies to underestimate an amount of divalent Sn and to overestimate an amount of tetravalent Sn if a value of a ratio of peak integrated absorption intensity of data at relatively high temperature (room temperature) is used as it is. Therefore, f was corrected by: fitting, by high-temperature approximation of the Debye model, the temperature dependence of absolute integrated absorption intensity for each site; and finding the Debye temperature for each site. Specifically, High-temperature Approximation Equation (1) of the Debye model was applied to the temperature dependency of the normalized integrated absorption intensity, and the Debye temperature was determined (found) for each sample and each site.

$$\ln f = - (6 E_R / k_B \theta_D^2) T \qquad (1)$$

$$E_R = E_\gamma^2 / 2 Mc^2 \qquad (2)$$

$$A = const. \times f \qquad (3)$$

f:      Recoil-free fraction
T:      Measurement temperature
$\theta_D$:     Debye temperature
$k_B$:     Boltzmann constant
$E_R$:     Recoil energy
$E_\gamma$:     Mossbauer gamma ray energy (23.87 keV)
M:      Recoil nuclear mass (118.90331 u)
c:      Light velocity
A:      Integrated absorption intensity

The obtained Debye temperatures were used to find the recoil-free fraction at each temperature by Equation (1) and correct the integrated absorption intensity and, then, an integrated absorption intensity ratio of tetravalent and divalent Sn sites was found. A value obtained from this ratio was set as a quantitative value independent of temperature.

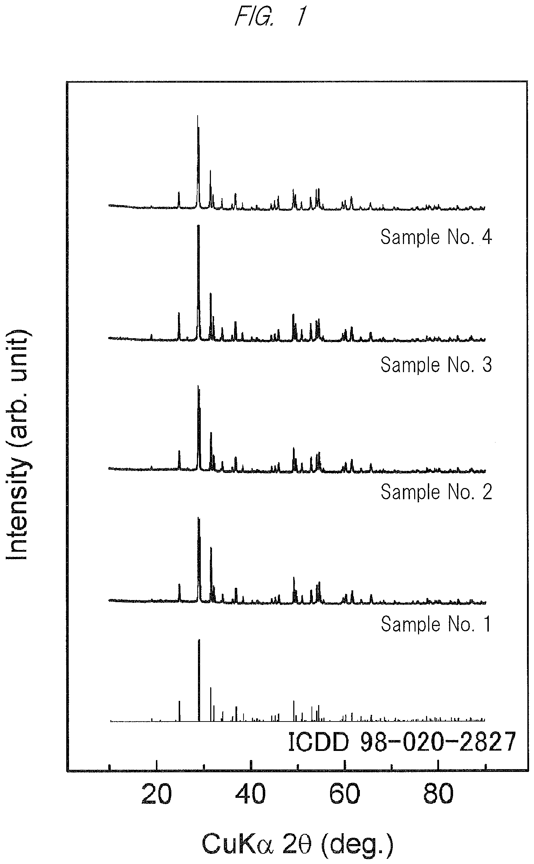

FIG. 1 shows an X-ray-diffraction-pattern change in main calcination temperatures about each sample of $SnNb_2O_6$. A horizontal axis in FIG. 1 indicates a diffraction angle $2\theta$ to an incident angle $\theta$ using a CuK$\alpha$ ray. The figure also shows X-ray diffraction patterns of $SnNb_2O_6$ foordite (98-020-2827) from ICDD (International Center for Diffraction Data) which is an X-ray database. The X-ray diffraction pattern in each case represents only a peak belonging to $SnNb_2O_6$ that has a foordite structure belonging to a monoclinic system. Understood from this can be that each of the sample numbers 1-4 in $SnNb_2O_6$ has a crystal structure having the foordite structure belonging to the monoclinic system regardless of a difference in the main calcination temperature.

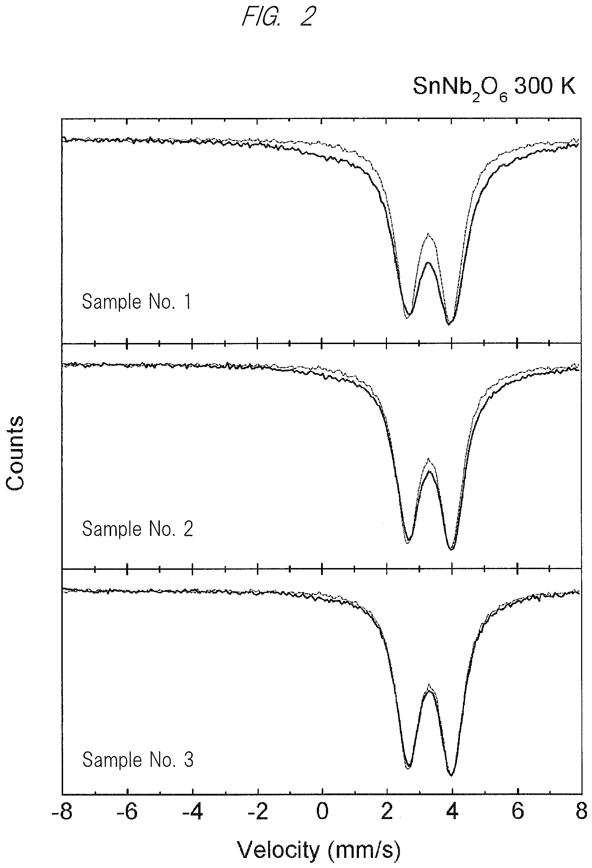

FIG. 2 shows, by solid lines, a change in $^{119}$Sn Mossbauer spectra at each main calcination temperature about the sample numbers 1-3 of $SnNb_2O_6$. Figure shows, by thin lines, a spectrum of $SnNb_2O_6$ (sample number 4) in which $Sn^{4+}$ hardly exists. Incidentally, measurement temperature of the spectrum is 300 K. A horizontal axis in FIG. 2 is the Doppler velocity. Three absorption peaks are observed in all the spectra. One weak peak near 0 mm / s is a peak due to $Sn^{4+}$, and two peaks at 2 to 6 mm / s are peaks due to $Sn^{2+}$. Therefore, coexistence of $Sn^{4+}$ and $Sn^{2+}$ in all the sample numbers 1-3 is understood.

Here, a ratio $Sn^{4+} / (Sn^{2+} + Sn^{4+})$ of $Sn^{4+}$ to the total Sn amount $(Sn^{2+} + Sn^{4+})$ is found from $^{119}$Sn Mossbauer spectrum. As described above, when the ratio is simply obtained from integrated absorption intensity ratios of these peaks, there are tendencies to underestimate the amount of divalent Sn and overestimate the amount of tetravalent Sn. Therefore, the integrated absorption intensity is corrected. The sample number 1 will be concretely described as an example.

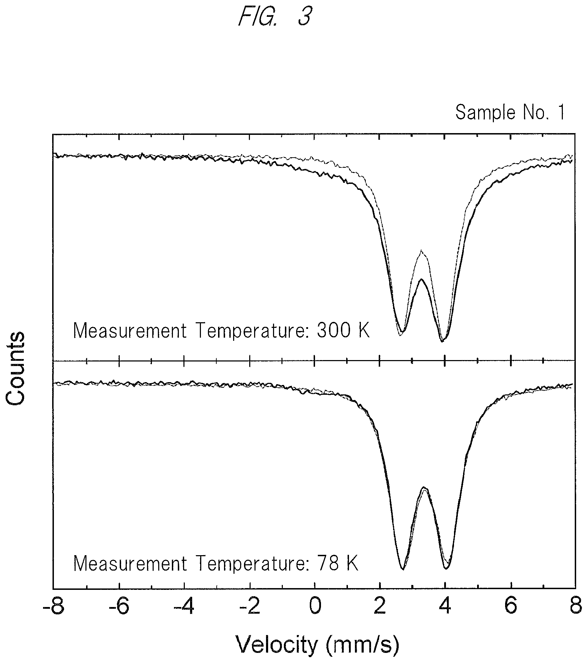

FIG. 3 shows, by solid lines, $^{119}$Sn Mossbauer spectra of the sample number 1 measured at 300 K and 78 K. Incidentally, for reference, the figure shows, by thin lines, spectra of $SnNb_2O_6$ (sample number 4) in which $Sn^{4+}$ hardly exists. First, a peak area (corresponding to integrated absorption intensity A) at each temperature is found. Since the integral absorption intensity A and the recoil-free fraction f have a relationship of Equation (3), a parenthesis on the right side of Equation (1) corresponds to an inclination representing a relationship (InA vs. T) between natural logarithm (InA) of the integrated absorption intensity and temperature T. Debye temperature $\theta_D$ was found from this inclination. Next, Equation (1) was used to find recoil-free fractions f at 300 K and 78 K from the found Debye temperature $\theta_D$. From a relationship between the obtained recoil-free fraction f at each temperature and the integrated absorption intensity A at the temperature, corrected integrated absorption intensity $A_{corr}$ when it is assumed that the recoil-free fraction f is equal to 1 (f = 1) was calculated as a quantitative value independent of measurement temperature.

Integrated absorption intensity A at the measurement temperature of 78 K was 0.004504 from the peak due to $Sn^{4+}$, and was 0.301744 from the peak due to $Sn^{2+}$. Integrated absorption intensity A at the measurement temperature of 300 K was 0.003433 from the peak due to $Sn^{4+}$ and was 0.148438 from the peak due to $Sn^{2+}$. The inclination ($\Delta InA / \Delta T$) (-0.00122 at $Sn^{4+}$ and -0.00320 at $Sn^{2+}$) was obtained from these integrated absorption intensities, and the Debye temperature $\theta_D$ (387 K at $Sn^{4+}$, and 237 K at $Sn^{2+}$) was obtained from these inclinations. From these Debye temperatures $\theta_D$, Equation (1) was used to find recoil-free fraction f at 78 K (0.9092 at $Sn^{4+}$ and 0.7791 at $Sn^{2+}$), and recoil-free fraction f at 300 K (0.6935 at $Sn^{4+}$ and 0.3829 at $Sn^{2+}$) was obtained. Next, the corrected integrated absorption intensity $A_{corr}$ when it is assumed that the recoil-free fraction ratio f is equal to 1 (f = 1) was found so that $Sn^{4+}$ is 0.0050 and $Sn^{2+}$ is 0.3877 at both of the measurement temperatures of 78K and 300K. Then, the corrected integrated absorption intensity $A_{corr}$ was calculated as a quantitative value independent of the measurement temperature. When this is expressed as an intensity ratio (sum is 1), the expression was calculated so that $Sn^{4+}$ is 0.013, $Sn^{2+}$ is 0.987, and $Sn^{4+} / (Sn^{2+} + Sn^{4+})$ is 0.013.

Table 1 collectively shows $Sn^{4+} / (Sn^{2+} + Sn^{4+})$ and electric measurement results (specific resistance, concentration of charge carriers, mobility, and Seebeck coefficient), which are found from $^{119}$Sn Mossbauer spectra, about samples different in main calcination temperature of $SnNb_2O_6$.

[Table 1]

| Sample Nos. | Production Conditions | Measurement Results | | | | |
|---|---|---|---|---|---|---|
| | Main Calcination Temperatures (K) | $Sn^{4+}/(Sn^{2+}+Sn^{4+})$ | Specific Resistance ($\Omega$cm) | Concentration of Charge Carriers (cm$^{-3}$) | Mobility (cm$^2$V$^{-1}$s$^{-1}$) | Seebeck Coefficients (VK$^{-1}$) |
| 1 | 1053 | 0.013 | $4.5 \times 10^0$ | $3.7 \times 10^{18}$ | $3.8 \times 10^{-1}$ | $+5.0 \times 10^{-5}$ |
| 2 | 1103 | 0.006 | $3.6 \times 10^4$ | - | - | $+3.0 \times 10^{-6}$ |

(continued)

| Sample Nos. | Production Conditions | Measurement Results | | | | |
|---|---|---|---|---|---|---|
| | Main Calcination Temperatures (K) | $Sn^{4+}/(Sn^{2+}+Sn^{4+})$ | Specific Resistance ($\Omega$cm) | Concentration of Charge Carriers ($cm^{-3}$) | Mobility ($cm^2V^{-1}s^{-1}$) | Seebeck Coefficients ($VK^{-1}$) |
| 3 | 1173 | 0.004 | - | - | - | - |
| 4 | 1473 | 0 | $9.0\times10^1$ | $1.3\times10^{16}$ | 5.2 | $-7.7\times10^{-6}$ |

In Table 1, the sample numbers 1-4 differ only in the main calcination temperature under production (preparation) conditions of $SnNb_2O_6$, so that electric characteristics like the samples (sample numbers 1-2) showing p-type conduction, the sample (sample number 3) showing insulating properties, and the sample (sample number 4) showing n-type conduction are different through the main calcination temperature are found to be different. $Sn^{4+}/(Sn^{2+}+Sn^{4+})$ in these samples is found indicating that each of the samples (sample numbers 1-2) showing the p-type conduction has a value higher than that of the sample (sample number 3) showing the insulating properties. Further, the samples (sample numbers 1-2) showing the p-type conduction are found indicating that the sample (sample number 1) with high concentration of charge carriers has a higher value of $Sn^{4+}/(Sn^{2+}+Sn^{4+})$ than that of the sample (sample number 2) with low concentration thereof. Namely, concentration of the holes which are charge carriers exhibiting p-type depends on a ratio of $Sn^{4+}$, and shows high concentration of the holes when the ratio of $Sn^{4+}$ is high. In other words, this means to have some relationship with the amount of structural defect $Sn'_B$ that produces the holes. Further, a case of at least $0.006 \leq Sn^{4+}/(Sn^{2+}+Sn^{4+}) \leq 0.013$ is found indicating (meaning) p-type conduction from the sample numbers 1-2.

(Second Embodiment)

Explained in the present embodiment will be a case of the oxide composite of the first embodiment to which a trace of element other than Sn and Nb is added. Even if the trace of elements is added, the added oxide composite exhibits p-type semiconductor characteristics similarly to those of the first embodiment when its crystal structure is a foordite structure.

[Production of Oxide Composite with Crystal Structure that includes Foordite Structure containing Sn and Nb and having Other Elements as Additional Elements]

Similarly to the production of the oxide composite in the first embodiment, SnO powder (High purity Materials KOJUNDO CHEMICAL LABORATORY CO. LTD, 99.5% purity) and $Nb_2O_5$ powder (High purity Materials KOJUNDO CHEMICAL LABORATORY CO. LTD, 99.9% purity) were weighed; $WO_2$ powder (Wako Pure Chemical Corporation, special grade) of 1.5 to 5.0 atom% was added to the weighed powders; and the added powders were placed in a mortar made of agate and were wet-mixed for about 1 hour while ethanol (Wako Pure Chemical Corporation, special grade) was added thereto.

Thereafter, the mixture was left overnight at room temperature to dry the ethanol, and was divided into 6 powder groups approximately equal to one another. Each power group was uniaxially pressurized (15 mm in diameter, 170 MPa) to produce six disk-shaped green compacts. The green compacts were placed on an alumina boat, put in an electric furnace having an alumina core tube whose diameter is 50 mm and whose length is 800 mm, and were temporarily calcined at 1173 K for 4 hours while nitrogen gas was caused to flow therein at a flow rate of 150 ml / minute. The temporarily calcined green compacts were crushed in the agate mortar, were mixed with ethanol after addition of a polyvinyl alcohol aqueous solution as a binder to a sample by 2 wt.%, and were left overnight at room temperature for drying. Then, the dried samples were sifted so that each of their particle size is adjusted to 212 $\mu$m or less, and were subjected to hydrostatic molding (285 MPa) after their uniaxial pressurization (15 mm in diameter, 170 MPa). Consequently, compacts each having a diameter of about 15 mm and a thickness of about 1.2 mm were produced. The obtained compacts were placed on an alumina boat, and were subjected to main calcination at 1053 K for 4 hours while nitrogen gas is caused flow (flow rate: 50 ml / min).

[Additional Elements and Electric Characteristics]

Table 2 collectively shows electric measurement results (specific resistance, concentration of charge carriers, mobility, and Seebeck coefficient) about samples in each of which 1.5 to 5.0 atom% of $WO_2$ is added as an additive compound.

[Table 2]

| Sample Nos. | Additive Amount (atm%) | Measurement Results | | | |
|---|---|---|---|---|---|
| | | Specific Resistance ($\Omega$cm) | Concentration of Charge Carriers ($cm^{-3}$) | Mobility ($cm^2V^{-1} s^{-1}$) | Seebeck Coefficients ($VK^{-1}$) |
| 5 | 1.5 | $1.7 \times 10^1$ | $2.1 \times 10^{18}$ | $1.7 \times 10^{-1}$ | $+5.8 \times 10^{-6}$ |
| 6 | 2.5 | $1.8 \times 10^1$ | $2.3 \times 10^{18}$ | $1.6 \times 10^{-1}$ | $+5.6 \times 10^{-6}$ |
| 7 | 3.5 | $2.2 \times 10^1$ | $2.0 \times 10^{18}$ | $1.4 \times 10^{-1}$ | $+4.8 \times 10^{-6}$ |
| 8 | 5.0 | $3.4 \times 10^1$ | $1.7 \times 10^{18}$ | $1.1 \times 10^{-1}$ | $+1.8 \times 10^{-6}$ |

In Table 2, $SnNb_2O_6$, to which 1.5 to 5.0 atom% of $WO_2$ were added, was found to be p-type semiconductor since its Seebeck coefficient took a positive value in each sample. Further, in each sample of the sample numbers 5-8, a peak due to $SnNb_2O_6$ was observed from X-ray diffraction measurements. In the sample of the sample number 8, a different phase due to an additive compound such as $WO_3$ was slightly observed in addition to the peak due to $SnNb_2O_6$. It is understood from this that the additive element is most preferably 3.5 atom% or less, but is also preferably 5 atom% or less since its Seebeck coefficient is found to take a positive value. If the additive element is 10 atom% or less, its impurities increase. However, since $SnNb_2O_6$ therein is a main crystal phase, a p-type semiconductor can be realized even if any different phases due to the additive element are slightly observed.

Although a concrete example of W has been shown as an additive element, an ion radius of W is 0.066 nm ($W^{4+}$) and is smaller 3.1% ($W^{4+}$) in difference than an ion radius (0.064 nm) of $Nb^{5+}$. Generally, it is said that a difference in size between an ion to be substituted and an ion of an additive element is within 15% to form a substitution type solid solution. Therefore, ion radii of Zr, V, Mn, Ti, Ga, Hf and Mo are also 0.072 nm (12.5% in difference), 0.064 nm (0.0% in difference), 0.065 nm (1.5% in difference), 0.061 nm (4.7% in difference), 0.062 nm (3.1% in difference), 0.071 nm (10.9% in difference), and 0.065 nm (1.5% in difference), respectively. As with W, since the difference therebetween is within 15%, the substitution type solid solution can be formed to a foordite structure. Namely, in addition to the above-mentioned defect in which $Sn^{4+}$ has substituted $Nb^{5+}$, defects in which any of these additional elements have been substituted for Nb are also considered as defects that generate holes, so that the p-type can be realized even when an almost equal amount of additive elements is added.

As described above, from the identification of the crystal phase by the X-ray diffraction, the evaluations of the electric characteristics by the Hall effect measurement and thermoelectric characteristic measurement, and the results of $Sn^{4+} / (Sn^{2+} + Sn^{4+})$ by the Mossbauer spectrum measurement, a compound represented by $SnNb_2O_6$ in a general chemical formula demonstrably has the crystal structure including the foordite structure and expresses the p-type semiconductor characteristics using holes as charge carries when the ratio $Sn^{4+} / (Sn^{2+} + Sn^{4+})$ of $Sn^{4+}$ to the total amount of Sn in a substance is $0.006 \leq Sn^{4+} / (Sn^{2+} + Sn^{4+}) \leq 0.013$. Further, the oxide semiconductor of the present invention can demonstrably realize the p-type oxide semiconductor even when having, as an additive element, at least one or more kinds of elements selected from a group composed of W, Zr, V, Mn, Ti, Ga, Hf, and Mo. The p-type oxide semiconductor can be realized even when the amount of the additive elements is 0.001 atom% or more and 10 atom% or less. Additionally, the total amount of the additive elements is preferably 0.001 atom% or more and 5 atom% or less, more preferably 0.001 atom% or more and 3.5 atom% or less.

Although a case of the bulk-like composite is exemplified by a producing method of the above-mentioned oxide composite, almost the same p-type characteristics are acquired also in thin film form. Thin-film oxide semiconductors can be produced by oxide thin-film producing techniques such as a spin coating method and a spray coating method that use a solution as a starting material in addition to vacuum deposition techniques such as a sputtering method, an evaporation method by heating or electron beams, and an ion plating method.

Incidentally, the examples shown in the above-described embodiments etc. are described to make the invention easily understood, and so the present invention is not limited to such embodiments.

## INDUSTRIAL APPLICABILITY

Since the oxide semiconductor of the present invention can realize the p-type semiconductor, the pn junction can be realized by the transparent n-type and p-type semiconductors in the visible light region, is widely usable in devices such as transmissive type displays and transparent transistors, and is industrially useful.

**Claims**

1. An oxide semiconductor comprising:

   a composite oxide having a crystal structure and containing Nb and Sn elements, the crystal structure including a foordite structure,
   wherein $Sn^{4+} / (Sn^{2+} + Sn^{4+})$ that is a ratio of $Sn^{4+}$ to a total amount of Sn in the composite oxide is $0.006 \leq Sn^{4+} / (Sn^{2+} + Sn^{4+}) \leq 0.013$, and
   its holes become charge carriers.

2. The oxide semiconductor according to claim 1,
   wherein the composite oxide is an oxide representing $AB_2O_6$ (A is Sn, and B is Nb) by a general chemical formula.

3. The oxide semiconductor according to claim 1 or 2,
   wherein at least one or more kinds of elements selected from a group composed of W, Zr, V, Mn, Ti, Ga, Hf, and Mo is added as additive element.

4. The oxide semiconductor according to claim 3,
   wherein a total amount of the additive element is 0.001 atom% or more and 10 atom% or less.

5. A semiconductor device including the oxide semiconductor according to any one of claims 1 to 4.

FIG. 1

Intensity (arb. unit)

Sample No. 4

Sample No. 3

Sample No. 2

Sample No. 1

ICDD 98-020-2827

20    40    60    80

CuKα 2θ (deg.)

FIG. 2

SnNb$_2$O$_6$ 300 K

Sample No. 1

Sample No. 2

Counts

Sample No. 3

Velocity (mm/s)

*FIG. 3*

Sample No. 1

Measurement Temperature: 300 K

Measurement Temperature: 78 K

Velocity (mm/s)

Counts

FIG. 4

Sn

O

Nb

a

c

b

**INTERNATIONAL SEARCH REPORT**

| International application No. |
| --- |
| PCT/JP2018/001729 |

**A. CLASSIFICATION OF SUBJECT MATTER**
Int.Cl.  C01G33/00(2006.01)i,  H01L29/786(2006.01)i

According to International Patent Classification (IPC) or to both national classification and IPC

**B. FIELDS SEARCHED**

Minimum documentation searched (classification system followed by classification symbols)
Int.Cl.  C01G25/00-47/00,     C01G49/10-99/00,     H01L29/76,     H01L29/78,
         B01J21/00-38/74

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)
CAplus/REGISTRY (STN), JSTPlus (JDreamIII), JST7580 (JDreamIII), JSTChina (JDreamIII)

**C. DOCUMENTS CONSIDERED TO BE RELEVANT**

| Category* | Citation of document, with indication, where appropriate, of the relevant passages | Relevant to claim No. |
| --- | --- | --- |
| A | KATAYAMA Shota et al., "Journal of Crystal Growth", 2015, vol. 416, pp. 126-129, ISSN 0022-0248 | 1-5 |
| A | CRUZ Luisa Paula et al., "Acta Crystallographica Section C Crystal Structure Communications", 2001, vol. 57 Part 9, pp. 1001-1003, ISSN 0108-2701 | 1-5 |
| A | JP 58-219703 A (E. I. DU PONT DE NEMOURS AND COMPANY) 21 December 1983, entire text & US 4548741 A1, entire text & US 4707346 A & EP 95775 A1 & KR 10-1988-0001308 B1 | 1-5 |
| A | JP 2004-344733 A (SUMITOMO METAL MINING CO., LTD.) 09 December 2004, entire text (Family: none) | 1-5 |

☐ Further documents are listed in the continuation of Box C.       ☐ See patent family annex.

| | | |
| --- | --- | --- |
| * | Special categories of cited documents: | |
| "A" | document defining the general state of the art which is not considered to be of particular relevance | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 27 February 2018 (27.02.2018) | 20 March 2018 (20.03.2018) |

| Name and mailing address of the ISA/ | Authorized officer |
| --- | --- |
| Japan Patent Office 3-4-3, Kasumigaseki, Chiyoda-ku, Tokyo 100-8915, Japan | Telephone No. |

Form PCT/ISA/210 (second sheet) (January 2015)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010010802 A

- JP 2006088019 A

**Non-patent literature cited in the description**

- **T. S. ERCIT ; P. CERNY.** *The Canadian Mineralogist,* 1988, vol. 26, 899-903
- **Y. HOSOGI ; Y. SHIMODAIRA ; H. KATO ; H. KOBAYASHI ; A KUDO.** *Chemistry of Materials,* 2008, vol. 20, 1299
- **P. CERNY ; A-M. FRANSOLET ; T. S. ERCIT ; R. CHAPMAN.** *The Canadian Mineralogist,* 1988, vol. 26, 889
- **L. P. CRUZ ; J. -M. SAVARIULT ; J. ROCHA ; J. -C. JUMAS ; J. D. PEDROSA.** *Journal of Solid State Chemistry,* 2001, vol. 156, 349
- **M. A. SUBRAMANIAN ; G. ARAVAMUDAN ; G. V. SUBBA RAO.** *Progress in Solid State Chemistry,* 1983, vol. 15, 55